# EUROPEAN PATENT APPLICATION

(11) **EP 4 779 692 A1**
(43) Date of publication of application: **22.07.2026**
(21) Application number: 24865764.5
(22) Date of filing: 05.09.2024
(51) Int. Cl.: H01L 25/075, H10H 29/01, H10H 20/813, H10H 20/851, H10H 20/857

(54) **FULL COLOR PIXEL FOR MICRO LED DISPLAY**

(30) Priority: 12.09.2023 KR 20230120795
(71) Applicant: Ryu, Yung Ryel, Irvine, California 92602 (US); Bang, Mun Whan, Gyeonggi-do 17840 (KR)
(72) Inventor: RYU, Yung Ryel, Irvine, California 92602 (US)
(74) Representative: Viering, Jentschura & Partner mbB Patent- und Rechtsanwälte
(86) International application number: PCT/KR2024/013393
(87) International publication number: WO 2025/058323

(57) **Abstract**

Proposed is a full-color pixel for a micro LED display, the full-color pixel including one or more red light micro LEDs, one or more green light micro LEDs, and one or more blue light micro LEDs while sharing a common n-electrode.

## Description

### Technical Field

The present disclosure relates generally to a full-color pixel for a micro LED display. More particularly, the present disclosure relates to a full-color pixel designed in a specific shape suitable for a next-generation micro LED display with ultra-high-resolution.

### Background Art

Recent improvements in high-quality thin-film growth technology and device processing technology have enabled the production of light-emitting devices of various sizes. In particular, micro LED display devices that reproduce full-color images by directly combining three primary colors of light by using blue light (B), green light (G), and red light (R) micro LEDs of 100*µ*m or less are being actively developed.

Traditionally, micro LED-based display manufacturing technologies are broadly divided into two methods depending on how RGB pixels are configured.

The first method is a method of forming an RGB pixel by combining a blue light micro LED, a green light micro LED, and a red light micro LED independent of each other, and the second method is method of forming an RGB pixel by combining a blue light micro LED and blue light micro LEDs each wrapped by a green light phosphor and a red light phosphor, respectively. Similarly to the latter case, an RGB pixel may be created by wrapping UV light micro LEDs each with a blue light phosphor, a green light phosphor, and a red light phosphor, respectively.

In the former case, productivity and yield are not high due to the difficulty of assembling the red light micro LED, the green light micro LED, and the blue light micro LED by transferring them to a display substrate to form an RGB pixel. In addition, in the case of the green light micro LED and the red light micro LED, luminous efficiency is very low compared to the blue light micro LED, thereby reducing the overall efficiency of the RGB pixel, and in the case of the red light micro LED, the red light micro LED is made of a non-nitride semiconductor, and is thermally unstable compared to the blue light micro LED and the green light micro LED made of a nitride semiconductor, so a light-emitting wavelength may easily change depending on an ambient temperature, making it difficult to establish stability of a reproduced color.

In the latter case, an RGB pixel is formed by wrapping blue light micro LEDs at specific locations with green and red light phosphors based on a blue light micro LED array according to a monolithic chip process, thereby realizing productivity superior to that of the former. However, it cannot be said that the latter case is technically easier than the former case since it is not easy to make the performance of the micro LEDs that constitute the array uniform and the conversion efficiency of the phosphors is different and not high.

Despite the advantages and disadvantages of the methods of forming a full-color pixel described above, micro LED light sources used in these methods are respectively manufactured with n/p-electrodes embedded therein. Since the micro LEDs produced in this way are required to have an area occupied by the n/p-electrodes, it is not easy to produce micro LEDs of 5*µ*m or less, which are necessary for implementing ultra-high resolution (5,000 pixel per inch (PPI) or more), by forming the full-color pixel based on micro LEDs with independent n/p-electrodes.

In addition, when an LED of each light source is manufactured with an independent electrode as the size of a micro LED decreases, it becomes increasingly technologically difficult to transfer micro LEDs and connect an electrode to a driver controller to form a display panel, making it difficult to form an ultra-high-resolution display with micro LEDs by using existing methods.

The difficulties described above necessitate the development of new types of micro LEDs to achieve full-color pixels required for an ultra-high-resolution display.

### Disclosure

### Technical Problem

Accordingly, the present disclosure has been made to solve the above problems occurring in the related art, and further to disclose a full-color pixel for a micro LED display, in which a red light micro LED, a green light micro LED, and a blue light micro LED constituting the full-color pixel share a common n-electrode, thereby enabling high integration of full-color pixels.

### Technical Solution

In order to achieve the objectives of the present disclosure, there is a full-color pixel provided for a micro LED display. The full-color pixel includes: one or more red light micro LEDs, one or more green light micro LEDs, and one or more blue light micro LEDs while sharing a common n-electrode.

In addition, each of the red light micro LED, the green light micro LED, and the blue light micro LED may be located at an equal distance around the common n-electrode.

In addition, the red light micro LED, the green light micro LED, and the blue light micro LED may be symmetrically arranged around the common n-electrode.

In addition, the red light micro LED, the green light micro LED, and the blue light micro LED may be formed to be arranged in a triangular shape around the common n-electrode.

In addition, the red light micro LED, the green light micro LED, and the blue light micro LED may be formed to be arranged in a quadrangular shape around the common n-electrode.

In addition, the red light micro LED, the green light micro LED, and the blue light micro LED may be formed to be arranged in a pentagonal shape around the common n-electrode.

In addition, the red light micro LED, the green light micro LED, and the blue light micro LED may be formed to be arranged in a hexagonal shape around the common n-electrode.

In addition, the red light micro LED may be implemented by wrapping the blue light micro LED with a red light conversion phosphor, and the green light micro LED may be implemented by wrapping the blue light micro LED with a green light conversion phosphor.

In addition, a size of the red light micro LED or the green light micro LED may be larger than a size of the blue light micro LED, or the size of the red light micro LED may be larger than the size of the green light micro LED.

In addition, the number of the red light micro LEDs or the green light micro LEDs may be greater than the number of the blue light micro LEDs, or the number of the red light micro LEDs may be greater than the number of the green light micro LEDs.

In addition, a size of the full-color pixel including the red light micro LED, the green light micro LED, and the blue light micro LED may be 0.01 to 10,000*µ*m².

### Advantageous Effects

According to the present disclosure, each of the red light micro LED, the green light micro LED, and the blue light micro LED constituting the full-color pixel is manufactured to have the common n-electrode, thereby reducing space required to form the full-color pixel, compared to a full-color pixel composed of micro LEDs having n-electrodes different from each other.

Accordingly, 5,000 full-color pixels of per inch (5,000 PPI) or more required for an ultra-high-resolution display can be integrated, thereby enabling useful application of the present disclosure to an ultra-high-resolution display required for VR/AR/MR displays.

In addition, the size and number of micro LEDs are easily controlled around the common n-electrode, thereby minimizing difference in luminous efficiency between each of the red light micro LED, the green light micro LED, and the blue light micro LED constituting the full-color pixel.

In addition, since it is possible to implement a plurality of micro LEDs around the common n-electrode, change in resolution thereof would be small even if an individual micro LED is defective, thereby reducing repair costs due to defect of a pixel.

In this way, according to the present disclosure, a next-generation display panel can be configured with a full-color micro LED display module based on RGB pixels composed of the red light micro LED, the green light micro LED, and the blue light micro LED, thereby enabling various and rich colors to be reproduced.

### Description of Drawings

FIG. 1 is a schematic diagram showing a micro LED display module composed of full-color pixels and an RGB pixel according to an embodiment of the present disclosure;
FIG. 2 is a schematic diagrams showing a full-color pixel with a red light micro LED, a green light micro LED, and a blue light micro LED arranged symmetrically in a triangular shape around a common n-electrode according to an embodiment of the present disclosure;
FIG. 3 is a schematic diagram showing a full-color pixel with a red light micro LED, a green light micro LED, and a blue light micro LED arranged symmetrically in a quadrangular shape around a common n-electrode according to an embodiment of the present disclosure;
FIG. 4 is a schematic diagram showing a full-color pixel with a red light micro LED, a green light micro LED, and a blue light micro LED arranged symmetrically in a pentagonal shape around a common n-electrode according to an embodiment of the present disclosure;
FIG. 5 is a schematic diagram showing a full-color pixel with a red light micro LED, a green light micro LED, and a blue light micro LED arranged symmetrically in a hexagonal shape around a common n-electrode according to an embodiment of the present disclosure; and
FIG. 6 is a view showing a blue micro LED array using full-color pixels arranged in a quadrangular shape around a common n-electrode according to the embodiment of the present disclosure.

### Mode for Invention

According to the present disclosure, since a red light micro LED, a green light micro LED, and a blue light micro LED that constitute a full-color pixel share a common n-electrode, a space required to constitute the full-color pixel may be reduced. Accordingly, it is possible to integrate 5,000 full-color pixels or more per inch (5,000 PPI) required for an ultra-high-resolution display, and thus a full-color pixel of the present disclosure may be applied suitably to the ultra-high-resolution display required for VR/AR/MR displays.

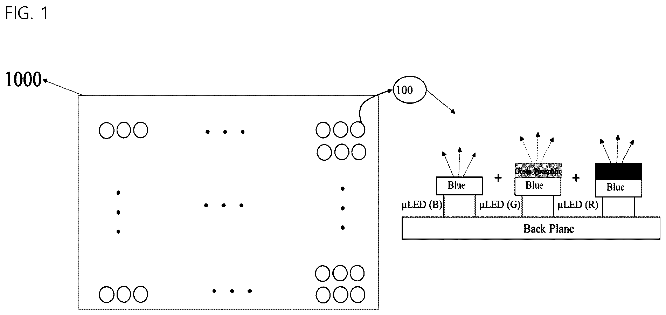

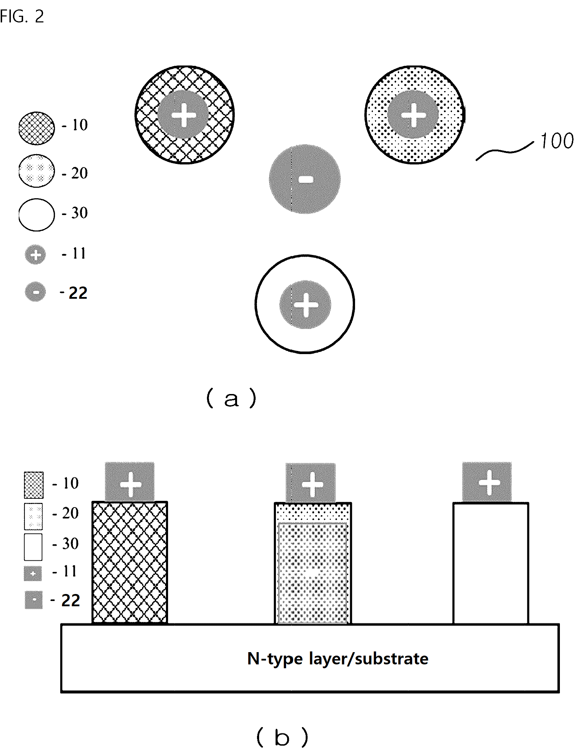

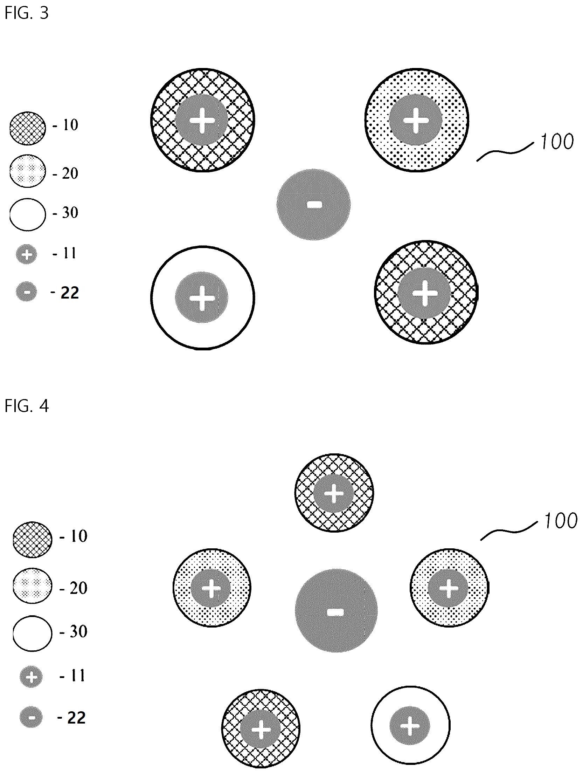

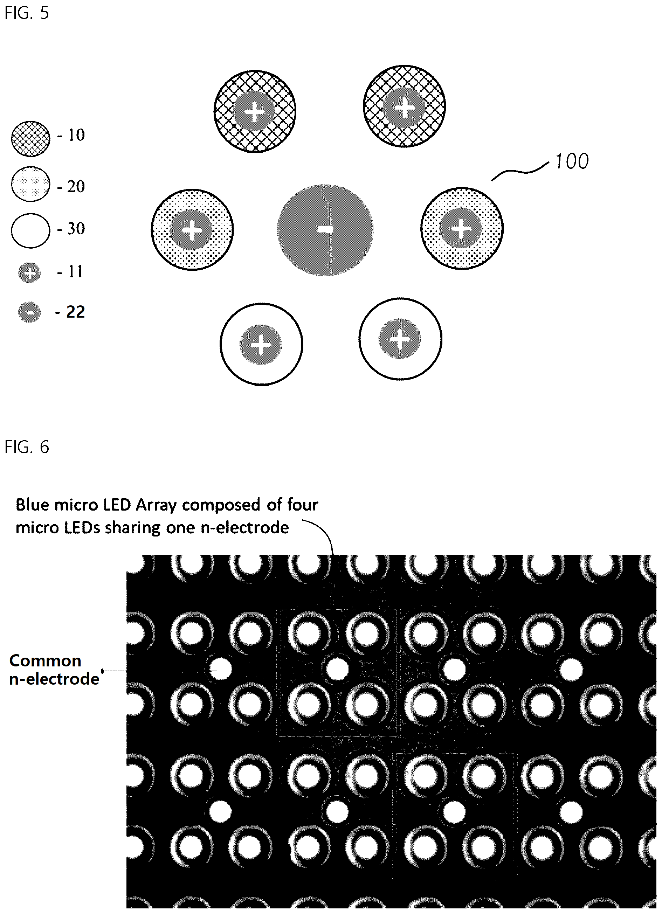

Hereinafter, an embodiment of the present disclosure will be described in detail with reference to the attached drawings: FIG. 1 is a schematic diagram showing a micro LED display module composed of full-color pixels and an RGB pixel according to an embodiment of the present disclosure; FIG. 2 is a schematic diagrams showing a full-color pixel with a red light micro LED, a green light micro LED, and a blue light micro LED arranged symmetrically in a triangular shape around a common n-electrode according to an embodiment of the present disclosure; FIG. 3 is a schematic diagram showing a full-color pixel with a red light micro LED, a green light micro LED, and a blue light micro LED arranged symmetrically in a quadrangular shape around a common n-electrode according to an embodiment of the present disclosure; FIG. 4 is a schematic diagram showing a full-color pixel with a red light micro LED, a green light micro LED, and a blue light micro LED arranged symmetrically in a pentagonal shape around a common n-electrode according to an embodiment of the present disclosure; FIG. 5 is a schematic diagram showing a full-color pixel with a red light micro LED, a green light micro LED, and a blue light micro LED arranged symmetrically in a hexagonal shape around a common n-electrode according to an embodiment of the present disclosure; and FIG. 6 is a view showing a blue micro LED array using full-color pixels arranged in a quadrangular shape around a common n-electrode according to the embodiment of the present disclosure.

As illustrated in the drawings, a full-color pixel 100 for a micro LED display according to the embodiment of the present disclosure shares a common n-electrode 22, and includes at least one red light micro LED 30, at least one green light micro LED 20, and at least one blue light micro LED 10.

In addition, according to the present disclosure, as illustrated in FIG. 1, a micro LED display module 1000 including at least one full-color pixel 100 is provided.

In general, in order for a micro LED display to be used in smart IT products including a smartphone and virtual reality reproduction products called VR/AR/MR, the total size of full-color pixels and a distance between the pixels are required to be manufactured within the range of 0.01 to 10,000*µ*m² and 0.1 to 100*µ*m, respectively. Accordingly, since the space allocated for the full-color pixels is very limited, it is very difficult to form the full-color pixel with independent single R/G/B LED chips with separate n-electrodes and p-electrodes.

In the present disclosure, a blue light micro LED array manufactured in a special shape to produce the full-color pixel 100, that is, the micro LED array is manufactured in a manner that micro LEDs constituting the full-color pixel 100 share the common n-electrode 22, thereby solving the problems caused by space limitation.

To solve this, each of the R/G/B micro LEDs may share the common n-electrode 22, and each of a red light micro LED 30, a green light micro LED 20, and a blue light micro LED 10 may be positioned at an equal distance from the common n-electrode 22. In addition, the red light micro LED 30, the green light micro LED 20, and the blue light micro LED 10 may be arranged symmetrically around the common n-electrode 22.

The full-color pixel 100 of the present disclosure is collectively called an RGB pixel, with each pixel emitting red light R, green light G, and blue light B, asthree primary color lights. In order to explain a preferred embodiment of the present disclosure, a pixel required for implementation of full color may be referred to as an RGB pixel, an RRGB pixel, an RGGB pixel, an RRGGB pixel, an RRRGB pixel, an RRRGGB pixel, an RRGGGB pixel, and an RRGGBB pixel, based on the number of light sources.

As illustrated in FIG. 1, in the array of blue light micro LEDs, some of the blue light micro LEDs 10, combined with a green light phosphor or a red light phosphor, may be used to form a red light source (the red light micro LED 30) and a green light source (the green light micro LED 20) necessary for full color reproduction. In this case, since the conversion efficiency of the phosphors, converting blue light into green light or blue light into red light, is different, the blue light micro LED 10, the green light micro LED 20, and the red light micro LED 30 may be so different in luminous efficiency.

To overcome this difference in luminous efficiency, the size of the red light micro LED 30 or the green light micro LED 20 is preferably formed larger than the size of the blue light micro LED 10. In addition, the size of the above red light micro LED 30 may be larger than the size of the above green light micro LED 20.

In addition, in another embodiment to overcome this difference in luminous efficiency, the number of the red light micro LEDs 30 or the green light micro LEDs 20 may be preferably greater than the number of the blue light micro LEDs 10. In addition, the number of the above red light micro LEDs 30 may be greater than the number of the above green light micro LEDs 20.

In addition, to ensure stable contact of the LEDs with the n-electrode and stable operation thereof, the shape and area size of the common n-electrode 22 may be adjusted as needed to form a specific type of the common n-electrode 22. For example, that is, each of the LEDs may have a larger area than a p-electrode 11 or may be formed in a specific shape suitable for the common n-electrode 22.

In an embodiment of the present disclosure, FIG. 2 shows the full-color pixel 100 (a trigon-type RGB-pixel) in which the red light micro LED 30, the green light micro LED 20, and the blue light micro LED 10 are arranged symmetrically in a triangular shape. That is, the red light micro LED 30, the green light micro LED 20, and the blue light micro LED 10 that constitute the pixel share the common n-electrode 22 and are arranged at uniform intervals from the common n-electrode 22 to have a regular triangular shape with symmetry.

In this way, when the red light micro LED 30, the green light micro LED 20, and the blue light micro LED 10 that form the full-color pixel 100 share the common n-electrode 22, an area required to form the full-color pixel 100 may be reduced, thereby facilitating the production of high-density pixels, and further, the production of the micro LED display module 1000 composed of the invented pixels.

The full-color pixel 100 according to the embodiment of the present disclosure illustrated in FIG. 2 is an RGB pixel composed of one red light micro LED 30, one green light micro LED 20, and one blue light micro LED 10 (R/G/B micro LEDs), with a total of three LEDs. In this case, green light and red light are generated by converting blue light into green light or red light by wrapping the blue light micro LED 10 with a green light conversion phosphor or a red light conversion phosphor as illustrated in FIG. 1.

The area of the full-color pixel 100 arranged in this way may be 0.01 to 10,000 *µ*m², more preferably 1 to 100 *µ*m², and an interval between the boundary of the common n-electrode 22 and the boundary of each of the micro LEDs may be 0.01 to 50 *µ*m, more preferably 0.1 to 2 *µ*m.

The micro LEDs have a problem in that luminous efficiency thereof decreases rapidly as the size of a chip decreases. Therefor, combined with low quantum conversion efficiency of phosphors the external quantum efficiency of the green light micro LED 20 is much lower than that of the blue light micro LED 10, and the red light micro LED 30 is much lower than that of the green light micro LED 20, if the green micro LED 20 and the red light micro LED 30 are the same in size as the blue light micro LED 10. In particular, it is difficult for the external quantum efficiency of the red light micro LED to exceed 1% when the chip size is 100µm² or smaller. To complement this problem, in order to prevent the external quantum efficiency of the red light micro LED 30 from decreasing in the embodiment of FIG. 2, the chip of the red light micro LED 30 may be manufactured to be larger than the size of the blue light micro LED 10.

FIG. 2(a) shows a schematic diagram of the full-color pixel 100 in a triangular shape when the full-color pixel 100 is viewed from above, and to help understanding, FIG. 2(b) shows a side view of the full-color pixel 100 in a triangular shape.

As another embodiment of the present disclosure, FIG. 3 illustrates a full-color pixel 100 in which the red light micro LEDs 30, the green light micro LED 20, and the blue light micro LED 10 are arranged symmetrically in a quadrangular shape. That is, the red light micro LEDs 30, the green light micro LED 20, and the blue light micro LED 10 that constitute the pixel share the same n-electrode as the common n-electrode 22 and are arranged symmetrically at uniform intervals from the common n-electrode 22 to have a quadrangular shape.

The full-color pixel 100 according to the embodiment of the present disclosure illustrated in FIG. 3 is an RRGB pixel (a square-type RRGB-pixel) composed of one green light micro LED 20, one blue light micro LED 10, and two red light micro LEDs 30. In this case, red light and green light are generated by converting blue light of a blue LED by using phosphors as described above.

The size of the full-color pixel 100 arranged in this manner may be 0.01 to 10, 000µm², more preferably, 1 to 100µm², and a distance between the boundary of the n-electrode 22 and the boundary of each of the micro LEDs may be 0.01 to 50µm, more preferably 0.1 to 2um.

In the case of FIG. 3, a reason in which the full-color pixel 100 is configured as RRGB instead of RGB is because, as described above, the external quantum efficiency of the red light micro LED 30 is very low compared to blue light micro LED 10. By using the two red light micro LEDs 30 as in the embodiment of FIG. 3, insufficient red light may be enhanced. Similarly, the present disclosure may be implemented by applying two green light micro LEDs 20 as needed instead of the red light micro LED.

In another embodiment of the present disclosure illustrated in FIG. 4 for a similar purpose to the embodiment of FIG. 3, micro LEDs may be arranged in a regular pentagonal pattern at uniform intervals around the common n-electrode 22. In this case, a full-color pixel 100 is an RRGGB pixel (a pentagon-type RRGGB-pixel) composed of one blue light micro LED 10, two red light micro LEDs 30, and two green light micro LEDs 20. In this case, red light and green light are produced by converting blue light with phosphors.

The size of the full-color pixel 100 arranged in this manner may be 0.01 to 10,000 µm², more preferably, 1 to 100 µm², and a distance between the boundary of the n-electrode 22 and the boundary of each of the micro LEDs may be 0.01 to 50µm, more preferably, 0.1 to 2µm.

In the embodiment of FIG. 4, the full-color pixel 100 may, in some cases, be an RRRGB pixel composed of three red light micro LEDs 30, one green light micro LED 20, and one blue light micro LED 10. Since it is possible to implement a plurality of red light micro LEDs 30 around the common n-electrode 22, change in resolution thereof is minimal even if an individual red light micro LED 30 is defective, so that repair costs due to the defect of the pixel can be reduced.

As another embodiment of the present disclosure, as illustrated in FIG. 5, R/G/B light sources constituting the full-color pixel 100 may be arranged in a regular hexagonal pattern at uniform intervals around the common n-electrode 22. In this case, the full-color pixel 100 is an RRGGBB pixel (a hexagon-type RGB-pixel) consisting of two blue light micro LEDs 10, two red light micro LEDs 30, and two green light micro LEDs 20. The RRGGBB pixel may operate as a single pixel, but may also be regarded as two independent full-color pixels 100.

Since it is possible to implement a plurality of micro LEDs around the common n-electrode 22, change in resolution thereof is minimal even if an individual micro LED is defective, so that repair costs due to the defect of the pixel can be reduced.

Even in the case of FIG. 5, red light and green light are generated by converting blue light with phosphors. The areas of the chips of these micro LEDs may be 0.01 to 10,000 *µ*m², more preferably 1 to 100 *µ*m², and an interval between the boundary of the common n-electrode 22 and the boundary of each of the micro LEDs may be 0.01 to 50 *µ*m, more preferably 0.1 to 2 *µ*m.

An embodiment of the present disclosure illustrated in FIG. 6 is an actual blue micro LED array using the full-color pixel 100 in a quadrangular shape illustrated in FIG. 3. It is shown that four blue micro LEDs share a common n-electrode 22 located in a center thereof so that the high-resolution full-color pixel 100 is achieved.

The blue light micro LED 10 may be made of a GaN-based nitride semiconductor. However, in the case of such a conventional GaN-based micro LED, as described above, since the luminous efficiency of the GaN-based micro LED tends to decrease rapidly when the chip size is 100*µ*m² or smaller, the blue light micro LED 10 may be manufactured as a Hybrid LED made of a GaN-based nitride semiconductor and a ZnO-based oxide semiconductor. The Hybrid LED may improve durability by increasing internal luminous efficacy (IQE) and reducing heat generation due to a surface leakage current. Applying this Hybrid LED as a micro LED required for the full-color pixel 100 of the present disclosure can solve problems related to the efficiency of conventional GaN light-emitting devices.

The full-color pixel 100 according to the present disclosure is manufactured in an integrated manner by using a monolithic process.

First, the blue light micro LED array is formed according to the disclosed arrangement of the full-color pixel 100, and phosphors capable of converting blue light into red light or green light are formed on some of the blue light micro LEDs 10 of the blue light micro LED array.

The blue light micro LEDs 10 are at least three independent light sources and are designed and manufactured in a monolithic manner so as to share the common n-electrode 22. The above micro LEDs are arranged symmetrically around the common n-electrode 22 to be located at the same distances from the common n-electrode 22. The micro LED display module 1000 may be manufactured by configuring the full-color pixel 100 composed of the blue light micro LED 10, the green light micro LED 20, and the red light micro LED 30 as a basic unit.

The blue light micro LED 10 may be composed of semiconductor materials such as GaN, or a hybrid semiconductor material made of ZnO and GaN.

The full-color pixel 100 composed of the micro LEDs may be configured with at least one blue light micro LED 10, at least one green light micro LED 20, and at least one red light micro LED 30.

Specifically describing an example of configuring the full-color pixel 100, the full-color pixel 100 may be composed of one blue light micro LED 10, one green light micro LED 20, and one red light micro LED 30.

As another example of configuring the full-color pixel 100, depending on a display usage environment, the full-color pixel 100 may be composed of one blue light micro LED 10, one red light micro LED 30, and two green light micro LEDs 20. Similarly, the full-color pixel 100 may be composed of one blue light micro LED 10, one green light micro LED 20, and two red light micro LEDs 30.

As another example of configuring the full-color pixel 100, the full-color pixel 100 composed of the micro LEDs may be composed of one blue light micro LED 10, two green light micro LEDs 20, and two red light micro LEDs 30.

As another example of configuring the full-color pixel 100, the full-color pixel 100 may be composed of two blue light micro LEDs 10, two green light micro LEDs 20, and two red light micro LEDs 30.

In this way, the full-color pixel of the present disclosure may be designed so that each of the R/G/B micro LEDs constituting the full-color pixel 100 may share the same n-electrode 22 to enhance the integration-density level, and each of the light sources constituting the full-color pixel 100 may be connected to a micro LED driving substrate (a CMOS backplane) by using flip-chip bonding technology.

In this way, according to the present disclosure, the red light micro LED 30, the green light micro LED 20, and the blue light micro LED 10 that constitute the full-color pixel share the common n-electrode 22, thereby reducing space required to constitute the full-color pixel.

Accordingly, it is possible to integrate 5,000 full-color pixels or more per inch (5,000 PPI) required for an ultra-high-resolution display, and thus a full-color pixel of the present disclosure may be applied usefully to the ultra-high-resolution display required for VR/AR/MR displays.

In addition, according to the present disclosure, when a next-generation display panel is configured with a full-color micro LED display module based on RGB pixels composed of the red light micro LED 30, the green light micro LED 20, and the blue light micro LED 10, thereby enabling various and rich colors to be reproduced.

## Claims

1. A full-color pixel for a micro LED display, the full-color pixel comprising:
one or more red light micro LEDs, one or more green light micro LEDs, and one or more blue light micro LEDs while sharing a common n-electrode,
wherein the common n-electrode includes one common n-electrode.

2. The full-color pixel of claim 1, wherein each of the red light micro LED, the green light micro LED, and the blue light micro LED is located at an equal distance around the common n-electrode.

3. The full-color pixel of claim 1, wherein the red light micro LED, the green light micro LED, and the blue light micro LED are symmetrically arranged around the common n-electrode.

4. The full-color pixel of claim 1, wherein the red light micro LED, the green light micro LED, and the blue light micro LED are formed to be arranged in a triangular shape around the common n-electrode.

5. The full-color pixel of claim 1, wherein the red light micro LED, the green light micro LED, and the blue light micro LED are formed to be arranged in a quadrangular shape around the common n-electrode.

6. The full-color pixel of claim 1, wherein the red light micro LED, the green light micro LED, and the blue light micro LED are formed to be arranged in a pentagonal shape around the common n-electrode.

7. The full-color pixel of claim 1, wherein the red light micro LED, the green light micro LED, and the blue light micro LED are formed to be arranged in a hexagonal shape around the common n-electrode.

8. The full-color pixel of claim 1, wherein the red light micro LED is implemented by wrapping the blue light micro LED with a red light conversion phosphor.

9. The full-color pixel of claim 1, wherein the green light micro LED is implemented by wrapping the blue light micro LED with a green light conversion phosphor.

10. The full-color pixel of claim 1, wherein a size of the red light micro LED or the green light micro LED is larger than a size of the blue light micro LED.

11. The full-color pixel of claim 10, wherein the size of the red light micro LED is larger than the size of the green light micro LED.

12. The full-color pixel of claim 1, wherein the number of the red light micro LEDs or the green light micro LEDs is greater than the number of the blue light micro LEDs.

13. The full-color pixel of claim 12, wherein the number of the red light micro LEDs is greater than the number of the green light micro LEDs.

14. The full-color pixel of claim 1, wherein a size of the full-color pixel including the red light micro LED, the green light micro LED, and the blue light micro LED is 0.01 to 10, 000*µ*m².
